# EUROPEAN PATENT APPLICATION

(11) **EP 0 619 607 A2**
(43) Date of publication of application: **12.10.1994**
(21) Application number: 94102895.3
(22) Date of filing: 25.02.1994
(51) Int. Cl.: H01L 23/495, H01L 23/31

(54) **Method for improved adhesion of polymeric adhesive and encapsulating material**

(30) Priority: 15.03.1993 US 31427
(71) Applicant: INTERNATIONAL BUSINESS MACHINES CORPORATION, Armonk, N.Y. 10504 (US)
(72) Inventor: Archambault, Helene, Granby, Quebec, J2H 2E8 (CA); Boutin, Lynda, Waterloo, Quebec, J0E 2N0 (CA); Kahn, Steven F. Robert, Burlington, Vermont 05401-1259 (US); Lajza, John James, Jr., Essex Junction, Vermont 05452 (US); Liutkus, John Joseph, Yorktown Heights, NY 10598 (US); Pare, Patrice, Bromont, Quebec, J0E 1L0 (CA); Peterson, Kirk David, Essex Junction, Vermont 05452 (US); Smith, Robert Michael, Minooshi, Osaka T562 (JP); Tremblay, Stephane, Deauville, Quebec, J1N 3P8 (CA)
(74) Representative: Kirchhof, Norbert, Ing. grad.

(57) **Abstract**

The invention provides a method of improving the adhesion between a polymeric adhesive (20, 22) and an encapsulating material (28) of the type used to encapsulate a semiconductor chip (14). The method involves the treatment of a polymeric adhesive so as to increase the number of bond sites to which the encapsulating material may adhere, thereby improving adhesion of the polymeric adhesive to the encapsulating material. The treatment may comprise oxidation, such as ozone oxidation, or high temperature baking, or plasma ashing, for example.

## Description

### TECHNICAL FIELD

This invention relates to a method of improving the adhesion between a polymeric adhesive and an encapsulating material of the type used to encapsulate a semiconductor chip. More particularly, it relates to a method which includes treatment of the polymeric adhesive so as to increase the number of sites to which the encapsulating material may adhere, thereby improving adhesion between the polymeric adhesive and the encapsulating material.

### BACKGROUND OF THE INVENTION

A useful method of packaging a semiconductor chip is known to those in the art as lead-on-chip packaging. This method is described in further detail in U.S. Patent No. 4,862,245, issued August 29, 1989, to Pashby et al. and entitled "Package Semiconductor Chip". The contents of U.S. Patent No. 4,862,245 are hereby incorporated by reference in order to more fully describe the state of the art to which the subject invention pertains.

Briefly, lead-on-chip packaging utilizes a lead frame having a plurality of conductors. The lead frame is attached to a major surface of a semiconductor chip using adhesives. Typically, a two-sided adhesive tape is utilized. One side of the adhesive tape is attached to the top or active side of the chip and the other or top side of the adhesive tape is attached to the lead frame. If desired, one side of the tape may be coated with a first adhesive and the other side of the tape may be coated with a second, different adhesive. The top side of the tape is often coated with a polymeric adhesive. Wires are then bonded to connect the terminals on the semiconductor chip to the lead frame conductors. The adhesive tape, semiconductor chip, wires, and portions of the lead frame are then encapsulated in an encapsulating material.

It is important to the lead-on-chip packaging method to obtain as strong an adhesion as possible between the adhesive on the top side of the adhesive tape and the encapsulating material. If the adhesion is not adequate, the integrity of the semiconductor chip package may be compromised.

A need thus exists for a method of improving the adhesion between the adhesive on the top side of the adhesive tape and the encapsulating material.

### SUMMARY OF THE INVENTION

This need for improved adhesion between the adhesive and the encapsulating material is met by the method of the subject invention.

Briefly described, the present invention is a method of improving the adhesion between a polymeric adhesive and an encapsulating material of the type used to encapsulate a semiconductor chip. The method comprises providing a polymeric adhesive of the type used in securing a chip to a lead frame or other structure. The polymeric adhesive is then treated so as to increase the number of bond sites where the polymeric adhesive contacts an encapsulating material to be used to encapsulate the chip. An encapsulating material is then applied to at least a portion of the polymeric adhesive. The treatment of the polymeric adhesive enhances the adhesion between the encapsulating material and the polymeric adhesive.

The treatment of the polymeric adhesive so as to increase the number of bond sites is preferably accomplished by ozone treatment, high temperature baking, or plasma ashing.

Treatment of the polymeric adhesive is preferably accomplished by exposure to ozone. However, other gases containing species which are reactive with the polymeric adhesive may also be used. One such example is nitrous oxide. Although ozone is known to degrade the entire structure of polymers, ozone exposure can be controlled to obtain a different effect. Exposure to controlled concentrations of ozone results in oxidation and increased numbers of bond sites. These increased numbers of bond sites provide for improved adhesion of the polymeric adhesive to the encapsulating material.

High temperature baking in the presence of oxygen-containing gases also operates to increase the number of bond sites between the polymeric adhesive
and the encapsulating material, allowing for improved adhesion. A temperature range between about 200°C and about 350°C allows such an increase without a detrimental effect on the entire structure of the polymeric adhesive.

In a further embodiment, plasma ashing is used to increase the number of bond sites. Such plasma ashing bombards the polymeric adhesive with ionically charged particles such as oxygen ions.

### BRIEF DESCRIPTION OF DRAWINGS

The foregoing and other objects, features and advantages of the invention will be apparent from the following more particular description of preferred embodiments of the invention as illustrated in the accompanying drawings in which:
FIG. 1 is an exploded schematic view showing the spatial relationship of the semiconductor chip, the polymeric adhesive, and the lead frame;
FIG. 2 is a partially cut-away schematic view showing an encapsulated lead-on-chip package, including the chip, adhesive, and lead frame shown in FIG. 1; and
FIG. 3 is a cross-sectional view of a portion of the encapsulated lead-on-chip package shown in FIG. 2.

### DETAILED DESCRIPTION OF THE INVENTION

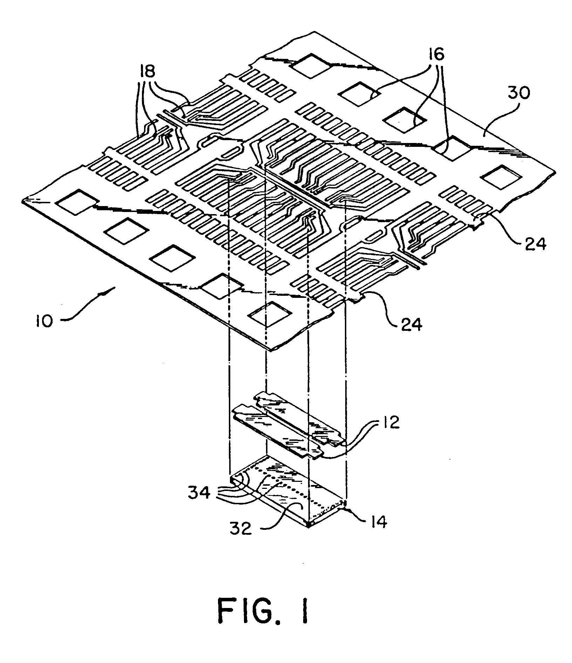

FIG. 1 is an exploded view of a lead frame 10, a two-sided adhesive tape 12, and a semiconductor chip 14 showing the spacial relationship of these elements in one example of lead-on-chip packaging. The lead frame 10 is produced from metal sheet stock and may include a plurality of indexing holes 16 and contains lead frame conductors 18. Such lead frames 10 are typically made from an iron-nickel alloy (e.g., alloy 42) or from a copper alloy and are well known and have a definite meaning in the semiconductor art. The material, thickness and strength of such lead frames has long been known to the art such that the use of the term "lead frame" as used in the art is all that is necessary to purchase such items. Some, but typically not all, portions of the lead frame conductors 18 that extend over the semiconductor chip 14 are separated from the semiconductor chip 14 by the two-sided adhesive tape 12.

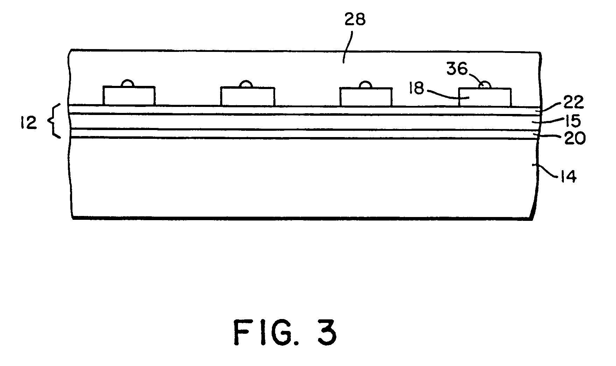

Referring to FIG. 3, the two-sided adhesive tape 12 has polymeric adhesive coatings 20 and 22, which are applied as thin films to the major surfaces of the tape 15 and are used to help secure the tape 15 to the lead frame 10 and the chip 14. If desired, the adhesive layers applied to the different sides of the tape 15 can be of different materials. The adhesive coating 22 securing the tape 15 to the lead frame 10 is preferably a polymeric adhesive such as a polyvinyl. The polyvinyl may be a polyvinyl butyral, which may include phenolics and epoxies. An example of an adhesive coating 22 as defined includes one sold by the Rogers Corporation of Chandler, Arizona under the tradename Rogers 8970. Rogers 8970 is a polyimide tape with an adhesive coating (polyvinyl butyral NN) on each side thereof. Other suitable adhesive coatings can be selected from the group of: an epoxy resin, a phenol resin (or resol), and a polyimide resin; a thermoset resin modified from the above-specified resins; and a thermoplastic resin such as aromatic polyether amide, polyether-ether-ketone, polysulfone, aromatic polyester imide, polyester or cycloaliphatic polyimide. It should be readily apparent that a tape made of a single thermoplastic material which reflows upon heating could also be utilized in place of the two-sided adhesive tape 12.

Cross members 24 are provided between the conductors 18 of the lead frame 10 to impart rigidity to the lead frame 10 and to limit flow of the encapsulating material when the semiconductor chip 14, the two-sided adhesive tape 12, and the conductors 18 are encapsulated.

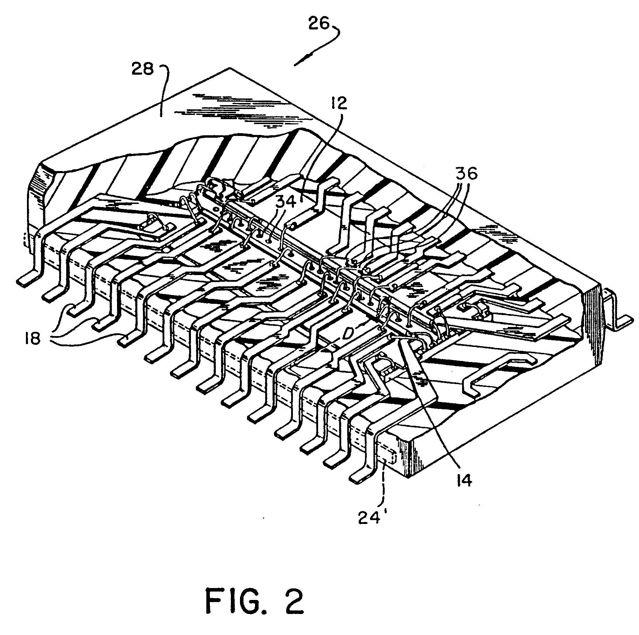

FIG. 2 shows a package 26 containing a semiconductor chip 14 in which part of the encapsulating material 28 has been removed. In this FIG. 2 the lead frame conductors 18 have their ends overlying the active surface 32 (see FIG. 1) of the semiconductor chip 14 intimately connected to pads 34 on the semiconductor chip 14 via gold wires 36 which are bonded to the chip pads 34 and to the lead frame conductors 18.

Once the lead frame conductors 18 have been suitably secured to the surface of the chip 14 and the wires 36 have been formed to connect the tips of selected lead frame conductors 18 to selected chip pads 34, the adhesive is cured at a relatively low temperature, e.g. 160° C. The encapsulating material 28 is then applied to form the package 26. The encapsulating material 28 is preferably an epoxy such as a novolac epoxy. An example of an encapsulating material 28 as defined herein includes one sold by Dexter Electronics Materials Division of Dexter Corporation under the name Hysol MG25F. Other suitable encapsulating materials can be molded from the group of: one or more major components, which are selected from an epoxy resin, a BT (Bismaleimide Triazine) resin, a phenol resin (i.e., resol), and a polyimide resin (e.g., aromatic polyimide or cycloaliphatic polyimide containing ether and carbonyl bonds); and an inorganic filler, a fibrous hardener or various additives, if necessary. Other examples from which the encapsulating material 28 can be molded are: a major component of a thermoplastic resin such as cycloaliphatic polyimide, polyester, polysulfone, aromatic polyether amide, aromatic polyester imide, polyphenylene sulfide, polyamide-imide or its modified, polyether etherketone, polyether sulfone or polyether amide-imide; and an inorganic filler, fibers and an additive, if necessary.

When considering the materials suitable for use together as the adhesive coating and the encapsulating material, it is important to consider that not all potential adhesive materials given above can be utilized with all potential encapsulating materials given above to obtain the benefits of the enhanced adhesion according to the subject invention. Suitable combinations can be readily determined by those skilled in the art.

After encapsulation, the lead frame selvage 30 and the cross members 24 shown in FIG. 1 are removed. The conductors 18 which extend beyond the package 26 have been formed using techniques well known to the art. The removed cross members are partially shown in phantom at 24' in FIG. 2.

The subject invention provides a method of treating the polymeric adhesive used in the lead-on-chip technology, other semiconductor packaging technologies, or other contexts in which an adhesive is encapsulated in a molding or encapsulating material to improve adhesion between the polymeric adhesive and the encapsulating material. The treatment involves modifying the adhesive to increase the number of sites where the encapsulating material can bond to the adhesive, preferably by ozone treatment, high temperature baking, or plasma ashing prior to encapsulation.

In one embodiment of the subject invention, the adhesive tape is subjected to oxidation in order to increase the number of bond sites. This is achieved by exposing the adhesive to ozone, or other gases such as nitrous oxide which contain species that are reactive with the polymeric adhesive. The oxidation of the polymeric adhesive (e.g., Rogers 8970) improves the adhesion to the encapsulating material (e.g., Hysol MG25F).

Ozone oxidation can be performed using commercially available ozone generators, such as the HT Series Ozone Generators of PCI Ozone & Control Systems, Inc. (West Caldwell, New Jersey). These generators are able to provide up to 10%, or about 100,000 parts per million, ozone. Generally, ozone oxidation is performed at room temperature by placing the adhesive in an ozone chamber for a predetermined time period at a predetermined ozone concentration.

Optimum time periods and ozone concentrations can be determined experimentally by treating the adhesive and analyzing if voids are present at the interface of the adhesive and the chip encapsulating material. Such analysis for voids can be readily performed by using acoustic microscope scans. Ozone concentrations in a range of about 10 parts per million up to 100,000 parts per million can be utilized to increase the number of bond sites on the adhesive for the encapsulating material. The higher the ozone concentration, the shorter the time period of oxidation that is required, assuming a constant temperature. Time periods in a range of about two minutes to about five hours can be used. Temperatures in the range of 0-60° C may be used, with temperatures in the range of 20-30° C being preferred. The low range of the ozone concentration, 10 parts per million, is believed to represent the lowest ozone concentration at which the number of bond sites is enough to result in improved adhesion of the encapsulating material, although somewhat lower concentrations may also provide satisfactory results for certain time and temperature combinations. The high range of the ozone concentration is believed to represent the ozone concentration at which the adhesive is damaged or burns for a given time and temperature. The high and low ends of the ozone concentration range will vary depending on the particular adhesive used.

The time, temperature, and ozone concentration interact to affect the results of the adhesive treatment. Examples of acceptable ozone concentrations, time periods, and temperature for Rogers 8970 are 10 parts per million for one to five hours at room temperature (about 25° C), up to 100,000 parts per million for two to five minutes at room temperature. A working embodiment for Rogers 8970 is 90 parts per million ozone concentration for one hour, at room temperature. Such treatment of the Rogers 8970 was designed to improve the adhesion thereof with respect to Hysol MG25F encapsulating material.

In another embodiment of the method of the subject invention, high temperature baking in the presence of oxygen-containing gases leads to increased numbers of bond sites between the adhesive and the encapsulating material. This results in enhanced adhesion of the adhesive to the encapsulating material. High temperature baking can be performed using commercially available ovens, such as the Electric Blue M oven, Model 256X-377, made by General Signal Company. In this embodiment, a temperature range of about 200°C to about 350°C can be utilized. The low end of the range is determined by practicality of the heating process. The high end of the range is determined by the substances utilized in the packaging process.

In the case of Rogers 8970, heating at about 200°C for three to four hours enhances adhesion. Heating at about 300°C for five minutes is also suitable. A working embodiment temperature/time combination is heating at about 220°C for about 1.5 hours.

The high temperature bake, like the ozone treatment, may rely on oxidation of the adhesive to enhance adhesion. This is evidenced by the requirement for some amount of oxygen for enhanced adhesion, i.e., at least about 1-2%. Room air is also suitable, which generally contains about 20% oxygen. If reduced amounts of oxygen are present, the amount of time required at a given temperature increases to achieve the same level of adhesion enhancement.

In a further embodiment of the subject invention, plasma ashing is used to enhance the adhesion of the adhesive to the encapsulating material. Plasma ashing tools are readily available, such as the Technics Model PP-1000-E of Technics Plasma (Florence, Kentucky). In plasma ashing, radiofrequencies are used to ionize the gases within a chamber. These ions then attack the adhesive placed within the chamber and the attack increases the number of bond sites for the encapsulating material to the adhesive.

In the case of Rogers 8970, about 2% to about 50% oxygen concentration can be utilized for about five to about 30 minutes. The pressure is between 200 and 1,000 millibars, with the temperature ranging from about 25°C to about 200°C. The pressure and temperature parameters are a result of the oxygen concentration and other process parameters. The plasma ashing tool operates at about 200 watts to about 1,500 watts.

A working embodiment for plasma ashing of Rogers 8970 is about 300 watts for about 10 to about 15 minutes, with about 10% oxygen. The temperature using these process parameters is about 50°C to about 75°C, and the pressure is about 1,000 millibars. Better adhesion between the adhesive and the encapsulating material is obtained at the lower end of the power range.

It is believed that at least for the ozone treatment and high temperature bake and quite probably for the plasma etching, the enhanced adhesion between the adhesive coating and the encapsulating material achieved with the present invention is the result of the conversion of oxidizable functionalities on the surface of the adhesive coating to functionalities which can react with functionalities of the encapsulating material. For example, in the context of a polyvinyl butyral adhesive coating and an epoxy novolac encapsulating material, a polyvinyl butyral adhesive coating includes ester, alcohol, and acetal functionalities. The acetal functionalities are an example of an oxidizable functionality. An epoxy novolac encapsulating material includes a high concentration of epoxy functionalities. The epoxy functionalities of the encapsulating material can react with the alcohol functionalities of the adhesive coating, but not with the ester or acetal functionalities.

Each of the treatments of the adhesive coating according to the subject invention, including the ozone treatment, high temperature bake, and plasma ashing, is believed to oxidize the acetal functionalities of such a polyvinyl butyral adhesive coating to ester and alcohol functionalities on the surface of the adhesive coating. These additional alcohol functionalities remain covalently bonded on the surface and can also react with the epoxy functionality of the epoxy novolac encapsulating material, resulting in enhanced adhesion.

As such, it should be readily apparent that the method of the invention has broader applicability beyond polymeric adhesive/encapsulating material contexts to a process for improving adhesion between an epoxy-based polymer and a substrate having a plurality of oxidizable functionalities. The substrate is treated with an oxidant to convert the oxidizable functionalities to alcohol functionalities, which can then react with the epoxy functionalities of the polymer. Such substrates could include standard polymers such as polypropylene and polyethylene, for example.

Similarly, although the method of improving adhesion between the adhesive and the encapsulating material according to the subject invention has been discussed in the context of lead-on-chip packaging, the invention is equally applicable to other chip packaging methods whenever improved adhesion between a polymer and an encapsulating material is desired. Such methods could include TAB (tape applied bonding) packaging and lead quad flat packaging. In lead quad flat packaging, which is used for example to package microprocessors, one-sided adhesive tape is used to stabilize the long leads used in the package.

Furthermore, the invention may be used in contexts other than semiconductor packaging, i.e., anywhere it is desired to improve the adhesion between an adhesive and an encapsulating material.

While the invention has been particularly shown and described with reference to preferred embodiments thereof, it will be understood by those skilled in the art that various changes in form and details may be made therein without departing from the spirit and scope of the invention.

## Claims

1. A method of improving the adhesion between a polymeric adhesive and an encapsulating material, the method comprising the steps of:
providing a polymeric adhesive;
treating said polymeric adhesive so as to increase the number of sites to which an encapsulating material may adhere; and
applying an encapsulating material to at least a portion of said polymeric adhesive so as to permit said encapsulating material to adhere to said polymeric adhesive.

2. The method of claim 1 wherein said treatment of said polymeric adhesive comprises oxidation of said polymeric adhesive.

3. The method of claim 2 wherein said oxidation of said polymeric adhesive comprises exposing said polymeric adhesive to ozone.

4. The method of claim 3 wherein said exposing to ozone comprises exposure to ozone in a range of about 10 to about 100,000 parts per million of ozone.

5. The method of claim 3 wherein said exposing to ozone comprises exposure to ozone at about 90 parts per million of ozone.

6. The method of claim 3 wherein said exposing to ozone comprises exposure to ozone for about two minutes to about five hours.

7. The method of claim 3 wherein said exposing to ozone comprises exposure to ozone at about 50 parts per million of ozone for about five hours at room temperature.

8. The method of claim 3 wherein said exposing to ozone comprises exposure to ozone at about 10,000 parts per million of ozone for about two minutes at room temperature.

9. The method of claim 3 wherein said exposing to ozone comprises exposure to ozone at about 90 parts per million of ozone for about one hour at room temperature.

10. The method of claim 1 wherein said treatment of said polymeric adhesive comprises baking said polymeric adhesive at a temperature in the range of about 200°C to about 350°C.

11. The method of claim 10 wherein said baking occurs in the presence of oxygen-containing gases.

12. The method of claim 1 wherein said treatment of said polymeric adhesive comprises baking said polymeric adhesive at a temperature of about 220°C.

13. The method of claim 10 wherein said baking is for about five minutes to about four hours.

14. The method of claim 1 wherein said treatment of said polymeric adhesive comprises baking said polymeric adhesive at about 200°C for about four hours.

15. The method of claim 1 wherein said treatment of said polymeric adhesive comprises baking said polymeric adhesive at about 220°C for about 1.5 hours.

16. The method of claim 1 wherein said treatment of said polymeric adhesive comprises baking said polymeric adhesive at about 350°C for about five minutes.

17. The method of claim 1 wherein said treatment of said polymeric adhesive comprises plasma ashing of said polymeric adhesive.

18. The method of claim 17 wherein said plasma ashing comprises exposing said polymeric adhesive to a range of about 10% to about 50% oxygen for about five to about thirty minutes at about 200 watts to about 1,500 watts.

19. The method of claim 17 wherein said plasma ashing comprises exposing said polymeric adhesive to about 10% oxygen for about 10 to about 15 minutes at about 300 watts.

20. The method of claim 1 wherein said polymeric adhesive comprises a polyvinyl.

21. The method of claim 20 wherein said polyvinyl comprises a polyvinyl butyral.

22. The method of claim 21 wherein said polyvinyl butyral comprises a phenolic polyvinyl butyral.

23. The method of claim 1 wherein said encapsulating material comprises an epoxy.

24. The method of claim 23 wherein said epoxy comprises a novolac epoxy.

25. A method of improving the adhesion between a polymeric adhesive and an encapsulating material, the method comprising the steps of:
providing a polymeric adhesive;
oxidizing said polymeric adhesive so as to increase the number of sites to which an encapsulating material may adhere; and
applying an encapsulating material to at least a portion of said polymeric adhesive so as to permit said encapsulating material to adhere to said polymeric adhesive.

26. A method of improving the adhesion between a polymeric adhesive and an encapsulating material, the method comprising the steps of:
providing a polymeric adhesive;
exposing said polymeric adhesive to ozone in a range of about 10 to about 100,000 parts per million of ozone so as to increase the number of sites to which an encapsulating material may adhere; and
applying an encapsulating material to at least a portion of said polymeric adhesive so as to permit said encapsulating material to adhere to said adhesive.

27. A method of improving the adhesion between a polymeric adhesive and an encapsulating material, the method comprising the steps of:
providing a polymeric adhesive;
baking said polymeric adhesive at a temperature range of about 200°C to about 350°C so as to increase the number of sites to which an encapsulating material may adhere; and
applying an encapsulating material to at least a portion of said polymeric adhesive so as to permit said encapsulating material to adhere to said polymeric adhesive.

28. The method of claim 27 wherein said baking occurs in the presence of oxygen-containing gases.

29. A method of improving the adhesion between a polymeric adhesive and an encapsulating material, the method comprising the steps of:
providing a polymeric adhesive;
exposing said polymeric adhesive to plasma ashing with a range of about 10% to about 50% oxygen for about five to about thirty minutes at about 200 watts to about 1,500 watts so as to increase the number of sites to which an encapsulating material may adhere; and
applying an encapsulating material to at least a portion of said polymeric adhesive so as to permit said encapsulating material to adhere to said polymeric adhesive.

30. A method of fabricating a semiconductor chip package, the method comprising the steps of:
providing a semiconductor chip;
applying a polymeric adhesive to a top surface of said semiconductor chip, said applied polymeric adhesive having an exposed top surface thereof;
attaching a lead frame to said exposed top surface of said polymeric adhesive;
treating said polymeric adhesive so as to increase the number of sites to which an encapsulating material may adhere; and
applying an encapsulating material to at least a portion of said exposed top surface of said polymeric adhesive so as to permit said encapsulating material to adhere to said exposed top surface of said polymeric adhesive, thereby encapsulating said semiconductor chip and said polymeric adhesive and said lead frame with said encapsulating material.

31. The method of claim 30 wherein said treating of said polymeric adhesive comprises oxidizing said polymeric adhesive.

32. The method of claim 31 wherein said oxidizing comprising exposing said polymeric adhesive to ozone.

33. The method of claim 30 wherein said treating of said polymeric adhesive comprises baking said polymeric adhesive at a temperature range of about 200°C to about 350°C.

34. The method of claim 30 wherein said treating of said polymeric adhesive comprises plasma ashing of said polymeric adhesive.

35. The method of claim 30 wherein said polymeric adhesive comprises a phenolic polyvinyl butyral.

36. The method of claim 30 wherein said encapsulating material comprises a novolac epoxy.

37. The method of claim 30, further comprising the step, after applying said polymeric adhesive and before attaching said leadframe, of curing said polymeric adhesive at a temperature of about 160° C.

38. A method for improving the adhesion between an epoxy-based polymer and a substrate having a plurality of oxidizable functionalities, said method comprising treating said substrate with an oxidant whereby a plurality of said oxidizable functionalities are converted to alcohol functionalities, and reacting said treated substrate with said epoxy-based polymer, wherein said alcohol functionalities of said treated substrate adhere to said epoxy-based polymer.

39. The method of claim 38 wherein said oxidant comprises ozone at 0° C to 60° C.

40. The method of claim 38 wherein said oxidant comprises oxygen at a temperature range of about 200° C to about 350° C.

41. The method of claim 38 wherein said oxidant comprises oxygen at a concentration of about 2% to about 50% for about five to about thirty minutes at about 200 watts to about 1,500 watts.

42. The method of claim 38 wherein said oxidizable functionalities comprise acetal functionalities.
